# EUROPÄISCHE PATENTANMELDUNG

(11) **EP 4 170 731 A1**
(43) Veröffentlichungstag der Anmeldung: **26.04.2023**
(21) Anmeldenummer: 21203335.1
(22) Anmeldetag: 19.10.2021
(51) Int. Cl.: H01L 31/042, H01L 31/02

(54) **BIFAZIALE PHOTOVOLTAIK-MODULE ZUR VERWENDUNG IN PHOTOVOLTAIK-ANLAGEN**

(71) Anmelder: Next2Sun GmbH, 66663 Merzig (DE)
(72) Erfinder: Die Erfindernennung liegt noch nicht vor
(74) Vertreter: Mertzlufft-Paufler, Cornelius

(57) **Zusammenfassung**

Zur Optimierung eines Photovoltaik-Moduls 1 hinsichtlich der Bedingungen bifazialer Stromproduktion in PV-Anlagen 29 wird vorgeschlagen, dass das PV-Modul 1 in Querorientierung zur Stromproduktion verwendet wird und dass daher mehrere Substrings 9, die aus einer jeweiligen linearen Anordnung von in Serie geschalteten gleichartigen photoaktiven Zellen 7 bestehen, entlang einer Querachse 5 des PV-Moduls 1 zueinander versetzt angeordnet werden. Dabei können die Substrings 9 so elektrisch verschalten werden, dass sich ein Stromfluss durch die in Einbausituation übereinander angeordneten Substrings 9 während der Stromproduktion unabhängig voneinander einstellt, sodass Verschattungen teilweise elektrisch kompensiert werden können

## Beschreibung

Die Erfindung betrifft ein bifaziales Photovoltaik(PV)-Modul mit je einer photoaktiven Fläche von rechteckiger Grundform auf einer Vorderseite und auf einer Rückseite des PV-Moduls, wobei die photoaktiven Flächen je eine Längsseite sowie eine kürzere Querseite ausbilden, die jeweils eine Längsachse beziehungsweise eine Querachse des PV-Moduls definieren. Hierbei können die photoaktiven Flächen jeweils durch mehrere Substrings von elektrisch in Serie geschalteten photoaktiven Zellen ausgebildet sein.

Die Erfindung betrifft ferner die Verwendung eines solchen Moduls zum Aufbau einer Photovoltaik-Anlage, die insbesondere in freiem Gelände installiert sein kann, und folglich auch eine Photovoltaik-Anlage, die derartige Module umfasst.

Seit längerem werden bereits bifaziale Photovoltaik(PV)-Module eingesetzt, die gegenüber herkömmlichen/klassischen monofazialen Photovoltaik-Modulen zahlreiche Vorteile bieten. Beispielsweise können bifaziale PV-Module senkrecht stehend montiert werden, um so Sonnenlicht aus östlichen Richtungen in den Morgenstunden mit der Vorderseite einzufangen und später am Tage weiteres Sonnenlicht aus westlichen Richtungen mit der Rückseite, wodurch eine elektrische Leistungsabgabe ermöglicht wird, die - anders als bei monofazialen Modulen - nicht in der Mittagszeit, sondern am Morgen und am Abend Maximalwerte erreicht.

Bei herkömmlichen Photovoltaik(PV)-Modulen haben sich in den letzten Jahren gewisse Industrie-Standards herausgebildet. So sind typischerweise 20-26 sogenannte Solarzellen (also photoaktive Zellen mit standardisierter aktiver Fläche) als Vollzellen zu einem sogenannten Substring in Serie verschaltet, wobei auch mehrere solcher Substrings elektrisch parallel geschaltet werden können, um die von dem Modul gelieferte Stromstärke zu erhöhen. Bei einer solchen elektrischen Verschaltung addieren sich somit die elektrischen Spannungen, die jede einzelne der Solarzellen innerhalb eines Substrings liefert, während sich die elektrischen Ströme parallel geschalteter Substrings addieren.

Ein hierbei grundlegendes Problem sind Verschattungen, also die mangelnde Beleuchtung einer Solarzelle, die zu geringem Stromfluss führt. Dies ist insbesondere deshalb kritisch, weil die geringe Stromproduktion einer einzelnen Solarzelle begrenzend wirkt auf den Stromfluss durch weitere Solarzellen, die zu der (teilweise oder sogar ganz) abgeschatteten Solarzelle in Serie geschalten sind. Eine einzelne abgeschattete Solarzelle kann so die Stromproduktion eines gesamten Substrings ausbremsen.

Typischerweise besteht deshalb jeder Substring aus einer elektrischen Serienschaltung von 20 bis 24 oder teilweise bis zu 26 photoaktiven Zellen (Solarzellen), wobei der gesamte Substring mittels einer Bypass-Diode elektrisch überbrückt werden kann, wenn eine starke Abschattung in (mindestens) einer der Solarzellen des Substrings auftritt. Die Bypass-Diode wird dabei antiparallel zu den photoaktiven Zellen geschaltet und ist daher im normalen Betriebszustand in Sperrrichtung gepolt. Liefert nun eine oder mehrere der Zellen keinen Strom, dann kann diese Zelle mittels einer Stromführung durch die Bypass-Diode, die dann in Durchlassrichtung durchschaltet, elektrisch überbrückt werden. Dadurch können insbesondere Hot Spots und Mindererträge bei der Stromausbeute des PV-Moduls vermieden werden. Die Sperrspannung einer Bypass-Diode muss somit etwas höher liegen, als die Summe der Leerlaufspannungen der Zellen, die zu der Bypass-Diode elektrisch parallel geschalten sind.

Darüber hinaus ist es auch möglich, mehrere Substrings elektrisch in Serie zu einem String zu verschalten. In diesem Fall fließt derselbe Strom durch alle Solarzellen des Strings, aber die Spannungen, die jeder einzelne der Substrings liefert, addieren sich zur Gesamtausgangsspannung des Strings.

Schließlich kann durch elektrisches in-Serie-Schalten mehrerer Solarmodule/PV-Module ein Modul-String erhalten werden. Hierbei addieren sich dann die Ausgangsspannungen der einzelnen PV-Module.

Seit einigen Jahren sind auch sogenannte Halbzellen-Solarmodule auf dem Markt erhältlich, bei denen die einzelnen Solarzellen von der Fläche her nur halb so groß sind im Vergleich zu sogenannten Vollzellen-Solarmodulen gleicher Baugröße; daher werden die Solarzellen solcher Module auch als Halbzellen bezeichnet. Die Halbzellen werden dabei durch mechanische Teilung von bereits vorprozessierten Vollzellen in quadratischer Grundform gewonnen, sodass die Halbzellen eine rechteckige Grundform aufweisen und die Fläche von zwei Halbzellen derjenigen einer Vollzelle entspricht.

Zwar liefern solche Halbzellen die gleiche Ausgangspannung wie Vollzellen, da diese durch die verwendeten HalbleiterMaterialien vorgegeben ist; da die Fläche einer Halbzelle jedoch nur halb so groß ist wie die einer Vollzelle, liefert eine Halbzelle näherungsweise auch nur den halben Strom. Andererseits können aufgrund der kleineren Fläche der Halbzelle somit in einem Standard-Solarmodul vorgegebener Baugröße doppelt so viele Strings von in Serie geschalteten Halbzellen erhalten werden, im Vergleich zu einem analogen Vollzellen-Solarmodul.

Die Vorteile der Verwendung von Halbzellen liegen in geringeren Leistungsverlusten, sodass die elektrische Ausgangsleistung eines Halbzellenmoduls ca. 2-3% über der eines vergleichbaren Vollzellenmoduls liegen kann. Ursächlich hierfür ist ein geringerer Stromfluss im Halbzell-Substring und hieraus resultierende geringere Leitungsverluste in den Zellen, aber auch ein verbessertes Temperaturverhalten und die geringere Anfälligkeit der Module gegen teilweise Verschattungen.

Möglich wird dieses verbesserte Verschattungsverhalten bei aktuell am Markt erhältlichen Halbzellenmodulen durch die Aufteilung des Moduls in zwei elektrisch voneinander getrennte Hälften, die unabhängig voneinander Licht in Strom umwandeln. Zusätzlich sorgen sogenannte Freilauf- oder Bypass-Dioden, die typischerweise in Längsrichtung mittig auf dem Modul angeordnet sind, dafür, dass eine Verschattung etwa einer Hälfte des Moduls sich nicht negativ auf die Stromproduktion in der anderen Hälfte auswirken kann. Aufgrund dieser verbesserten Leistung von Halbzellenmodulen setzten sich diese immer mehr auf dem Markt durch.

Ausgehend hiervor besteht die Aufgabe der Erfindung darin, neue Designs von bifazialen Photovoltaik-Modulen aufzuzeigen, die den technischen Rahmenbedingungen Rechnung tragen, wie sie bei der Verwendung solcher PV-Module in senkrechter Aufstellung an PV-Anlagen im Freien auftreten, und so zu einer verbesserten Stromproduktion und zu einer Kostenreduzierung in diesem konkreten Anwendungsfall führen.

Zur Lösung dieser Aufgabe sind erfindungsgemäß bei einem PV-Modul die Merkmale von Anspruch 1 vorgesehen. Insbesondere wird somit erfindungsgemäß zur Lösung der Aufgabe bei einem PV-Modul der eingangs genannten Art vorgeschlagen, dass eine jeweilige Stromrichtung der Substrings in Richtung der Längsachse ausgerichtet ist (hierbei können auch gegenläufige Stromrichtungen innerhalb eines Substrings auftreten) und dass die Substrings so elektrisch verschalten und angeordnet sind, dass (insgesamt) ein räumlicher Netto-Stromtransport entlang der Längsachse des PV-Moduls erzielbar ist.

Nur zum Verständnis sei an dieser Stelle angemerkt, dass bei einem solchen PV-Modul - wie im Stand-der-Technik üblich - die photoaktiven Flächen der Vorderseite und der Rückseite jeweils durch dieselben photoaktiven Zellen ausgebildet sein können. Die Zellen werden somit im Betrieb jeweils entweder von vorne oder von hinten mit Sonnenlicht bestrahlt (je nach Tageszeit) und können so insbesondere morgens und nachmittags elektrischen Strom aus Sonnenstrahlung erzeugen. Mit anderen Worten können demnach die beiden photoaktiven Flächen gerade deckungsgleich angeordnet sein, insbesondere sodass diese durch eine gemeinsame Einhüllende begrenzt sind.

Unter einem Modul kann hier generell eine bauliche Einheit verstanden werden, die insbesondere einen das PV-Modul fassenden Rahmen aufweisen kann. Wie der Name schon sagt, können solche baulichen Einheiten dazu verwendet werden, eine PV-Anlage modulartig aus solchen PV-Modulen aufzubauen.

Mit anderen Worten wird also vorgeschlagen, die Substrings so anzuordnen und elektrisch miteinander zu verschalten, dass im Betrieb des PV-Moduls ein räumlicher Gesamt-Netto-Stromfluss durch das PV-Modul entlang dessen Längsachse erfolgt, beispielsweise von einem ersten Anschluss-Terminal zu einem zweiten Anschlussterminal.

Die Erfindung hat hierbei erkannt, dass die Verwendung möglichst langer PV-Module effizient ist, um kostengünstige bifaziale PV-Anlagen zu konzipieren und zu errichten. Hierbei steigt jedoch der Verkabelungsaufwand, weil bei herkömmlichen Modulen ohne derartigen Netto-Stromtransport in Längsrichtung dieser durch zusätzliche Kabel geleistet werden muss, die entlang der Längsseite des Moduls geführt werden müssen, um zwei (in Längsrichtung) benachbarte Module zu einer Modul-Serie zu verschalten (was typischerweise in solchen Anlagen erforderlich ist). Die Verwendung von langen PV-Modulen ist vorteilhaft, weil sie eine vereinfachte und damit kostengünstigere Tragkonstruktion ermöglicht. Die vorgeschlagene Verschaltung, die sich in mannigfaltigen Varianten ausgestalten lässt, wie noch genauer unten erläutert wird, verringert den Verkabelungsaufwand erheblich, was auch zu einer einfacheren Ausgestaltung der Tragkonstruktion beiträgt, etwa weil weniger Kabeldurchführungen ausgestaltet werden müssen. Der Verzicht auf wie bislang übliche Verkabelungen führt auch dazu, dass weniger oder gar keine Kabel mehr (je nach PV-Anlage) in den Pfosten und/oder zwischen aktiven Flächen geführt werden müssen. Dadurch werden auch kritische Abschattungen durch Kabel vermieden, die die Stromausbeute des PV-Moduls verringern.

Die bifazialen PV-Module können Solarzellen aufweisen, die von beiden Seiten bestrahlt werden können, um jeweils Strom zu generieren. In diesem Fall kann eine einzige elektrische Verschaltung der Solarzellen ausreichend sein.

Bifaziale PV-Module im Sinne der Erfindung können aber auch beispielsweise über sogenannte Tandem-Solarzellen realisiert sein, die jeweils eine photoaktive Schicht auf der Vorder- und Rückseite aufweisen. Die jeweilige Solarzelle kann dann mehr als zwei elektrische Terminals aufweisen. In einem solchen Fall kann die vorgeschlagene elektrische Verschaltung beispielsweise spiegelbildlich auf der Vorder- und auf der Rückseite des PV-Moduls ausgestaltet sein. Dadurch kann dann, insbesondere sowohl auf der Vorder- als auch auf der Rückseite, ein räumlicher Netto-Stromtransport entlang der Längsachse des PV-Moduls im normalen Betrieb (also während der Stromproduktion) erzielt werden, unabhängig davon, welche Seite des PV-Moduls gerade mit Sonnenlicht bestrahlt wird.

Die Substrings können sich bei einem erfindungsgemäßen Design beispielsweise gemäß einer ersten Option dadurch auszeichnen, dass die räumliche Stromrichtung aller photoaktiven Zellen eines Substrings einheitlich ist (sodass also kein Richtungswechsel der Stromrichtung innerhalb des Substrings auftritt). Somit kann ein jeweiliger Substring des PV-Moduls selbst einen räumlichen Nettostromtransport in Längsrichtung des PV-Moduls erzielen, nämlich wenn alle photoaktiven Zellen eines Substrings dieselbe räumliche (Netto-) Stromtransportrichtung zeigen. Somit gibt es dann innerhalb eines solchen Substrings gerade keinen Wechsel der Nettostromtransportrichtung.

Gemäß einer zweiten Option können die Substrings aber auch mäandrierend ausgestaltet sein. In diesem Fall weist der Substring photoaktive Zellen auf, deren räumliche Stromrichtung gerade entgegengesetzt ist. Dennoch sind aber auch bei einer solchen Ausgestaltung alle Zellen des Substrings elektrisch in Serie geschalten und direkt zueinander benachbart. Zur verbesserten Stromführung können dabei kurze Stromleitungen eingesetzt werden, etwa an Wendepunkten, an denen sich die Stromrichtung der Zellen umkehrt.

Diese zweite Option kann insbesondere derart ausgestaltet sein, dass mindestens zwei, insbesondere drei Sub-Substrings, die eine gleiche Anzahl an photoaktiven Zellen aufweisen, mäandrierend zu dem Substring elektrisch in Serie geschalten sind. Hierbei sind dann die räumlichen Stromrichtungen aller photoaktiven Zellen eines Sub-Substrings gleich, während einzelne der Sub-Substrings des Substrings (im Vergleich zueinander) entgegengesetzte räumliche Stromrichtungen aufweisen können. Durch solche Ausgestaltungen lässt sich somit innerhalb eines Substrings, der vorzugsweise mittels (wenigstens) einer zugeordneten Bypass-Diode elektrisch überbrückbar ist, sowohl eine Hin-und-Her-Stromführung (unter Verwendung von zwei gleich langen übereinander angeordneten Sub-Substrings) als auch beispielsweise eine Hin-Her-Hin-Stromführung (unter Verwendung von drei gleich langen übereinander angeordneten Sub-Substrings), jeweils über die gesamte Längsseite des PV-Moduls, umsetzen, wie noch genauer anhand von Ausführungsbeispielen erläutert werden wird.

Ferner können die photoaktiven Zellen eines Substrings und/oder eines Sub-Substrings, insbesondere ohne Zwischenräume, unmittelbar benachbart nebeneinander innerhalb des Moduls platziert sein, um so eine bestmögliche Flächenausnutzung zu gewährleisten.

Generell ist es dabei vorteilhaft, wenn das PV-Modul Bypass-Dioden aufweist, mit denen ein jeweiliger Substring oder auch ein ganzer String aus mehreren Substrings elektrisch überbrückbar ist. Eine solche Bypass-Diode kann hierbei als passives oder aber als aktives (also insbesondere elektronisch steuerbares) Bauteil ausgestaltet sein. Beispielsweise können heutige Wechselrichter Verschattungssituationen erkennen und dann gezielt einzelne aktive Bypass-Dioden aktivieren / durchschalten.

Zur Lösung der eingangs genannten Aufgabe sind daher erfindungsgemäß bei einem PV-Modul, ergänzend oder aber alternativ zu den zuvor beschriebenen Merkmalen, die Merkmale von Anspruch 2 vorgesehen. Insbesondere wird somit erfindungsgemäß zur Lösung der Aufgabe bei einem PV-Modul der eingangs genannten Art, welches jedoch zudem noch wenigstens eine Bypass-Diode aufweist mit der mehrere der photoaktiven Zellen elektrisch überbrückbar sind, ergänzend oder alternativ vorgeschlagen, dass an die wenigstens eine Bypass-Diode eine im Normalbetrieb stromlose Bypass-Stromleitung angeschlossen ist. Diese Bypass-Stromleitung ist dabei so ausgelegt und/oder angeordnet, dass sie im Bypass-Betrieb Strom parallel zur (d.h. insbesondere in Richtung der) Stromrichtung eines der Substrings bis zu einem elektrischen Knotenpunkt transportieren kann. Hierbei ist es vorzuziehen, wenn die Bypass-Stromleitung im Bypass-Betrieb Strom parallel zu wenigstens zwei photoaktiven Zellen dieses Substrings (also insbesondere entlang dieser wenigstens zwei Zellen) transportieren kann. Die Stromrichtung des Substrings kann hierbei gerade die Richtung des elektrischen Stroms sein, welches der Substring im Normalbetrieb (ohne nennenswerte Abschattung) erzeugt. Der Knotenpunkt kann bevorzugt ein T-Knotenpunkt sein, an welchem drei Stromleitungen zusammengeführt sind (z.B. die Bypass-Stromleitung, eine Stromableitung eines ersten Substrings und die Stromzuleitung eines zweiten Substrings).

Die Erfindung unterscheidet hier demnach zwischen normalstromführenden Leitungen (Stromleitung), also Leitungen die bei normalem Betrieb der Solarzellen stromführend sind, und nur im Bypass-Betrieb stromführenden Leitungen (sogenannte Bypass-Stromleitungen), also Leitungen durch die Strom fließt, wenn eine Solarzelle mittels einer Bypass-Diode (die dann in Durchlassrichtung betrieben wird) elektrisch überbrückt wird.

Vorteilhaft an der oben beschriebenen Ausgestaltung ist, dass die Bypass-Stromleitung im Bypass-Betrieb die wenigsten zwei photoaktiven Zellen des Substrings, d.h. je nach Ausgestaltung auch den gesamten Substring, elektrisch überbrücken kann und so einen Stromtransport in Längsrichtung des PV-Moduls auch im Bypass-Betrieb weiterhin gewährleisten kann.

Der Knotenpunkt kann bevorzugt elektrisch innerhalb eines Strings (insbesondere ausgestaltet als Serienschaltung von mindestens zwei Sub-Strings) angeordnet sein, der die von der Bypass-Diode elektrisch überbrückten wenigstens zwei Zellen, insbesondere einen von der Bypass-Diode elektrisch überbrückten Substring, umfasst. Im Ergebnis muss die Bypass-Diode, an welcher die Bypass-Stromleitung angeschlossen ist, nicht mehr in der Nähe dieses Knotenpunkts lokalisiert sein. Dadurch können PV-Module mit im Vergleich zu vorbekannten Modulen vergrößerter Gesamtlänge ausgestaltet werden, wie anhand der Ausgestaltungsbeispiele deutlich werden wird.

Durch die beschriebene Ausgestaltung der Bypass-Stromleitung wird somit eine räumliche Entkopplung der Anordnung der Bypass-Dioden von der Anordnung der Substrings erzielt. Dadurch kann eine größere zusammenhängende photoaktive Fläche geschaffen und so die Effizienz der solaren Stromerzeugung verbessert werden. Zudem kann dadurch die Gesamtlänge eines aus den Substrings gebildeten Strings wesentlich vergrößert werden, wodurch längere PV-Module erhalten werden können.

Durch die Verwendung einer derartigen Bypass-Leitung ist es somit möglich, die Anordnung der Bypass-Diode von dem besagten Knotenpunkt räumlich zu entkoppeln. Ein Abstand zwischen dem Knotenpunkt und der Bypass-Diode kann somit mehr als zwei Längen der jeweiligen Zellen (in Stromrichtung) betragen; im Extremfall kann der besagte Abstand sogar mehr als die Länge der Längsseite der photoaktiven Fläche betragen.

Die vorgeschlagene Serienschaltung von räumlich getrennten Substrings innerhalb des PV-Moduls ermöglicht weitere technische Vorteile, die im Folgenden anhand weiterer bevorzugter Ausgestaltungen erläutert werden. Insbesondere können übliche Strom-Spannungs-Werte (wie Sie für bislang erhältliche PV-Module typisch sind) weiterhin erzielt werden und es können bereits etablierte Fertigungstechnologien zur Herstellung der erfindungsgemäßen PV-Module genutzt werden.

Beispielsweise kann vorgesehen sein, dass wenigstens zwei der Substrings elektrisch in Serie zu einem String geschalten sind und der erwähnte Knotenpunkt den String elektrisch unterteilt, etwa in mindestens zwei elektrisch aufeinander folgende Substrings. Vorzugsweise kann der String hierbei eine Serienschaltung von einer Anzahl an N photoaktiven Zellen realisieren, deren aufsummierte Leerlaufspannungen eine Durchbruchsspannung einer der photoaktiven Zellen übersteigen.

Der besagte String kann somit beispielsweise mehr als 24, insbesondere mehr als 26, photoaktive Zellen umfassen und dennoch kann der String auf derselben Seite des PV-Moduls enden, an welcher er beginnt (Hin-und-Her-Stromführung über die gesamte Längsseite des PV-Moduls). Denn im Falle einer Teilabschattung eines der den String bildenden Substrings kann dieser Substring mittels der beschriebenen Bypass-Stromleitung elektrisch überbrückt werden, wobei Strom über die Bypass-Stromleitung bis zum Knotenpunkt transportiert wird. Zwischen dem Knotenpunkt und einem Endpunkt des Strings kann dann erneut ein Substring mit einer Anzahl an M photoaktiven Zellen realisiert sein, deren aufsummierte Leerlaufspannungen gerade noch unterhalb einer jeweiligen Durchbruchsspannung der photoaktiven Zellen liegen (Somit kann insbesondere gelten: Gesamtzahl N an Zellen des Strings > M).

Die erfindungsgemäße Bypass-Stromleitung kann bevorzugt entlang der Längsachse ausgerichtet sein. In diesem Fall kann sie sogar über die gesamte Längsseite der photoaktiven Fläche verlaufen oder etwa entlang von wenigstens zwei Zellen.

Ferner kann die Bypass-Stromleitung gerade so ausgestaltet sein, dass eine Hin-und-Her-Stromführung über die gesamte Längsseite hinweg durch einen String ermöglicht ist. Denn bei vorbekannten PV-Modulen, bei denen die Strings nicht mittels einer Bypass-Stromleitung elektrisch unterteilt sind, ist eine solche Hin-und-Her-Stromführung nur dann möglich, wenn die Gesamtanzahl N an Zellen des betroffenen Strings die von der Bypass-Diode vorgegebene maximale Anzahl nicht überschreitet.

Die erfindungsgemäße Lösung mit separater Bypass-Stromleitung, die Strom parallel zur Stromrichtung eines Substrings transportiert, ermöglicht hingegen wesentliche längere Strings mit einer Gesamtanzahl N von in Serie geschalteten Zellen, die die besagte maximale Anzahl übertrifft. So kann beispielsweise ein String aus 2 x 24=48 Zellen gebildet werden, der eine Hin-und-Her-Stromführung über die gesamte Längsseite des PV-Moduls realisiert.

Bei solchen Ausgestaltungen ist es demnach vorzuziehen, wenn der String von dem elektrischen Knotenpunkt in wenigstens zwei Substrings elektrisch unterteilt ist, deren photoaktive Zellen zumindest teilweise gegenläufige Stromrichtungen aufweisen. Der elektrische Knotenpunkt muss dabei nicht zwingend am äußeren Rand der photoaktiven Fläche platziert sein (dies wäre eine symmetrische Unterteilung); vielmehr ist auch ein elektrischer Abgriff in der Mitte möglich, sodass der Knotenpunkt einen String elektrisch auch in unterschiedliche lange Substrings unterteilen kann (asymmetrische Unterteilung).

Gemäß einer weiteren vorteilhaften Ausgestaltung kann die Bypass-Stromleitung und/oder die wenigstens eine Bypass-Diode (an welcher die Bypass-Stromleitung angeschlossen ist) außerhalb einer Einhüllenden der photoaktiven Fläche(n) angeordnet sein. Dies hat den Vorteil, dass eine große nicht unterbrochene/zusammenhängende photoaktive Fläche entsteht.

Alternativ kann es bei bestimmten Ausführungen, die noch genauer beschrieben werden, notwendig oder vorteilhaft sein, wenn die Bypass-Stromleitung innerhalb einer Einhüllenden der zugeordneten photoaktiven Fläche(n) angeordnet ist.

Schließlich sind bei Verwendung einer erfindungsgemäßen Bypass-Stromleitung auch Ausgestaltungen denkbar, bei denen eine Polachse, die durch zwei Anschluss-Terminals des PV-Moduls verläuft, entlang der Querachse ausgerichtet ist.

Ferner können auch mindestens zwei der Substrings in Richtung der Querachse räumlich über- beziehungsweise nebeneinander angeordnet sein und elektrisch in Serie zu einem, insbesondere dem zuvor erwähnten, String geschalten sein. In einem solchen Fall kann also insbesondere der Knotenpunkt den String elektrisch in die mindestens zwei Substrings unterteilen.

Unabhängig von der Ausgestaltung einer erfindungsgemäßen Bypass-Stromleitung, also insbesondere bei einem erfindungsgemäßen PV-Modul mit räumlichen Netto-Stromtransport in Längsrichtung des PV-Moduls, kann gemäß bevorzugten Ausgestaltungen vorgesehen sein, dass eine Polachse, die durch zwei Anschluss-Terminals des PV-Moduls verläuft, entlang der Längsachse ausgerichtet ist. Hierunter kann insbesondere verstanden werden, dass diejenige Komponente der Polachse, die in Richtung der Längsachse verläuft, gegenüber der verbleibenden Komponente der Polachse überwiegt (also länger als diese ausgestaltet ist). Die Polachse beziehungsweise der zugehörige Polvektor kann somit auch eine (kleinere) Komponente in Richtung der Querachse des PV-Moduls aufweisen; d.h. auch eine schräge Anordnung des Polvektors kann noch entlang der Längsachse des PV-Moduls ausgerichtet sein. Durch solche Ausgestaltungen ist gerade erreichbar, dass, insbesondere innerhalb des besagten Strings und/oder entlang der gesamten Längsseite des PV-Moduls, ein Netto-Stromtransport (während des normalen Betriebs des PV-Moduls) erfolgt.

Über die Anschluss-Terminals kann das PV-Modul elektrisch mit anderen PV-Modulen in Serie geschalten werden, etwa innerhalb einer PV-Anlage. Je nach Design der PV-Anlage, können einzelne PV-Module auch elektrisch parallel geschalten sein. Hierbei können die Anschluss-Terminals und/oder wenigstens eine Bypass-Diode bevorzugt außerhalb einer Einhüllenden (als gedachte Linie, die die photoaktiven Flächen einhüllt), angeordnet sein. Ferner ist es für eine einfache Verkabelung und zur Vermeidung von Abschattungen vorzuziehen, wenn die Terminals und/oder die wenigstens eine Bypass-Diode an der Längsseite des PV-Moduls angeordnet ist/sind.

Ferner ist es bei einem solchen Design vorteilhaft, wenn mindestens zwei der Substrings in Richtung der Querachse des PV-Moduls räumlich übereinander (beziehungsweise nebeneinander, je nach Betrachtungswinkel) angeordnet sind und elektrisch in Serie zu einem String geschalten sind. In einer typischen Einbausituation, also dann wenn die Längsachse als auch die Flächennormale des Moduls in etwa horizontal verläuft, sind die Substrings, die in Serie geschalten sind, somit (zumindest teilweise) dann vertikal übereinander angeordnet.

Je nach Verschaltung können einzelne Substrings eines Strings auch entgegengesetzte Stromrichtungen zeigen. Hierdurch kann nämlich eine mäandrierende Hin-Her-Hin-Stromführung innerhalb eines Strings realisiert sein. Bei dieser Hin-Her-Hin-Stromführung wird also der von den Solarzellen des Strings erzeugte Strom zunächst in Längsrichtung, dann entgegen der Längsrichtung und schließlich wieder in Längsrichtung geführt.

Entsprechend kann es bei einer solchen mäandrierenden Stromführung innerhalb eines Strings (oder auch innerhalb eines Substrings) somit eine Stromtransportkomponente geben, die in Querrichtung des PV-Moduls verläuft.

Gemäß einer spezifischen Ausgestaltung des PV-Moduls ist vorgesehen, dass jeweils drei Substrings zu dem besagten String elektrisch in Serie geschalten sind (wobei das PV-Modul selbstverständlich mehrere solcher Strings aufweisen kann). Dadurch kann erreicht werden, dass eine Hin-Her-Hin-Stromführung mit zwei Stromrichtungswechseln durch den (jeweiligen) String realisiert ist.

Eine Gesamtzahl M an photoaktiven Zellen (Solarzellen), die in einem der Substrings in Serie geschalten sind, kann beispielsweise auf sechsundzwanzig, bevorzugt auf fünfundzwanzig, besonders bevorzugt auf vierundzwanzig begrenzt sein, um so zu verhindern, dass es bei einer Abschattung einer der Zellen (durch welche diese in den unbestrahlten Zustand wechselt und damit zu einem hochohmigen elektrischen Verbraucher wird) zu einem elektrischen Durchbruch kommt. Mit anderen Worten kann also die Gesamtzahl M so begrenzt sein, dass eine Summe der Leerlaufspannungen der M Zellen eine Durchbruchsspannung einer der photoaktiven Zellen nicht übersteigt. Hierbei kann insbesondere ein jeweiliger String des PV-Moduls mindestens zwei, insbesondere mindestens drei oder sogar mindestens vier solcher Substrings aufweisen, um so geeignete Ausgangsspannungswerte des PV-Moduls zu erzielen. Jeder dieser Substrings kann über eine zugeordnete Bypass-Diode elektrisch überbrückbar sein. Bei Verwendung von maximal drei Substrings kann die Gesamtzahl an photoaktiven Zellen des Strings somit beispielsweise nicht mehr als achtundsiebzig, vorzugsweise nicht mehr als zweiundsiebzig betragen. Je nach Layout des PV-Moduls können somit typischerweise zwischen 40 und 96 photoaktive Zellen elektrisch zu einem String miteinander verschalten sein.

Gemäß einem wiederum anderen Design, welches sich von vorbekannten Ansätzen löst, können in einem der Substrings auch mehr als vierundzwanzig photoaktive Zellen elektrisch in Serie geschalten sein. In diesem Fall kann insbesondere jeweils nur ein String zwischen zwei Anschluss-Terminals des PV-Moduls elektrisch geschalten sein. Bevorzugt können dann aber wiederum mindestens zwei Strings des PV-Moduls zwischen den Anschluss-Terminals elektrisch parallel geschalten sein, um eine ausreichende Stromstärke zu produzieren. Bei einem derartigen Design kann demnach eine Gesamtzahl N an photoaktiven Zellen elektrisch derart in Serie geschalten sein, dass eine Summe der Leerlaufspannungen der N Zellen eine Durchbruchsspannung einer der photoaktiven Zellen übersteigt. Bei einer solchen Ausgestaltung werden somit bislang übliche Grenzwerte überschritten und die gewöhnliche Grenze der Durchbruchsspannung des verwendeten Halbleitermaterials ignoriert. Hierfür muss demnach die Kontaktierung der einzelnen Zellen durchbruchsfest ausgelegt sein, was sich aber beispielsweise durch Verzicht auf Polymere und die Verwendung thermisch stabiler Einbettungsmaterialien erreichen lässt.

Wie bereits eingangs erläutert wurde, können einzelne Substrings übereinander angeordnet sein (in Einbauposition). Gleiches gilt auch für die Strings des PV-Moduls. Eine solche Übereinander-Anordnung von einzelnen (räumlich getrennten) Strings des PV-Moduls kann, insbesondere bei Einbau des PV-Moduls mit der Längsseite in horizontaler Richtung (in der PV-Anlage), vorteilhaft sein, um die Anfälligkeit des PV-Moduls gegen Verschattungen zu verringern.

Gemäß einer spezifischen Ausgestaltung kann daher wenigstens eine der aktiven Flächen mindestens zwei Strings aufweisen, die in Richtung der Querachse des PV-Moduls zueinander versetzt, also insbesondere in Richtung der Querachse benachbart zueinander, angeordnet sind, um so die gewünschte Übereinander-Anordnung im Betrieb zu erzielen. Dadurch kann insbesondere erreicht werden, dass bei Verwendung des PV-Moduls in einer Querorientierung, in welcher die Längsseite horizontal ausgerichtet ist, mindestens zwei, vorzugsweise jedoch mindestens drei, Strings vertikal übereinander angeordnet sind (also innerhalb des PV-Moduls). Bei solchen Ausgestaltungen kann das PV-Modul dann entsprechende Bypass-Dioden zur elektrischen Überbrückung einzelner der Strings aufweisen. Diese Bypass-Dioden können im Falle einer Abschattung automatisch eine Stromumleitung bewirken.

Bei derartigen Ausgestaltungen ist zu bedenken, dass die bloße Übereinander-Anordnung von einzelnen Substrings innerhalb eines Strings noch keinen Vorteil gegen Verschattung schafft, jedenfalls dann, wenn die Substrings eines jeweiligen Strings elektrisch in Serie geschalten sind und nicht separat elektrisch überbrückbar sind. Bei Abschattung beispielsweise eines unteren Strings (bezogen auf die Montage-Situation), kann dieser aber mittels einer Bypass-Diode elektrisch überbrückt werden, während ein benachbarter oberer nichtabgeschatteter String des PV-Moduls weiterhin eine maximale Stromproduktion liefern kann.

Bei allen hier vorgestellten Modul-Designs kann bevorzugt vorgesehen sein, dass die photoaktiven Zellen (jeweils) als N-Bruchteilzellen, also insbesondere als Halbzellen, ausgestaltet sind. Die N-Bruchteilzellen, insbesondere die Halbzellen, können auch hier bevorzugt eine rechteckige Grundform aufweisen, beziehungsweise eine rechteckige photoaktive Fläche ausbilden. Schließlich ist es auch hier zu bevorzugen, wenn eine jeweilige Längsseite der N-Bruchteilzelle, die länger ist als eine zugehörige Querseite der N-Bruchteilzelle, in Richtung der Querachse des PV-Moduls ausgerichtet ist.

Die im Markt bereits teilweise verwendeten Halbzellen sind somit mit dem erfindungsgemäßen Konzept kompatibel. Daher wird vorgeschlagen, dass die photoaktiven Zellen des PV-Moduls (jeweils auf der Vorder- bzw. Rückseite) jeweils als eine N-Bruchteilzelle, also insbesondere als eine Halbzelle, Drittelzelle, oder Viertelzelle, ausgestaltet sein können. Wie eingangs bereits erläutert wurde, können derartige N-Bruchteilzellen aus einer vorprozessierten Vollzelle durch Teilung in N Bruchteile hergestellt werden.

Bei Verwendung solcher N-Bruchteilzellen für das PV-Modul ist aus Gründen der einfacheren Fertigung und einer guten Flächenausnutzung vorzuziehen, wenn diese N-Bruchteilzellen jeweils eine rechteckige Grundform aufweisen, beziehungsweise jeweils eine rechteckige photoaktive Fläche ausbilden.

Typische Prozessschritte, die zur Herstellung der N-Bruchteilzellen auf ein Halbleitermaterial noch vor der Teilung desselben in N-Bruchteile angewandt werden, können zum Beispiel sein: Das Vereinzeln des Halbleitermaterials (z.B. vorliegend als ein mono- oder polykristalliner Rohling (Ingot)) in Wafer; eine anschließende Oberflächenbehandlung (Reinigen, Ätzen, Polieren etc.); eine Dotierung zur Erzeugung des notwendigen PN-Übergangs; das Aufbringen von Antireflexionsschichten (wie etwa Siliziumnitrid) oder mikrooptischen Strukturen; und gegebenenfalls bereits das Aufbringen von Leiterbahnen zur Kontaktierung der einzelnen photoaktiven Zellen. Zeigt die Vollzelle beispielsweise die typische quadratische Grundform, so weisen die hieraus resultierenden N-Bruchteilzellen eine rechteckige Grundform auf, wobei die Teilungslinien parallel verlaufen können (z.B. bei Drittel- oder Viertelzellen). Die Teilung kann somit bevorzugt entlang einer gleichbleibenden Vorzugsrichtung erfolgen. Eine solche Teilung lässt sich beispielsweise auch auf ein Halbleitermaterial-Endlosband vorgegebener Breite anwenden. Insbesondere bei Verwendung von polykristallinem Ausgangsmaterial kann auch bereits die Vollzelle eine rechteckige Grundform aufweisen. Durch das Vereinzeln in Wafer kann es dabei auch vorkommen, dass Ecken einer rechteckigen Grundform der N-Bruchteilzellen abgerundet sind. Das Teilen einer derart vorprozessierten (photoaktiven) Vollzelle in eine Anzahl von N Bruchteilzellen wird im Stand der Technik häufig durch Lasern einer Sollbruchkante bewerkstelligt, entlang derer das Halbleitermaterial dann kontrolliert gebrochen werden kann.

Auch bei Verwendung von N-Bruchteilzellen können aufgrund des erfindungsgemäßen Verschaltungskonzepts der aus den N-Bruchteilzellen gebildeten Substrings vergleichsweise lange PV-Module erhalten werden, um so kostengünstige PV-Anlagen zu ermöglichen.

Die Verwendung von N-Bruchteilzellen bei bifazialen PV-Modulen gemäß dem erfindungsgemäßen Konzept kann dabei die Stromausbeute, die Effizienz und die Ausgangsleistung des PV-Moduls erhöhen. Denn eine jeweilige Längsseite einer einzelnen N-Bruchteil-Zelle (also insbesondere einer verwendeten Halbzelle) des PV-Modul, die länger ist als eine zugehörige Querseite der N-Bruchteilzelle, kann dabei bevorzugt in Richtung der Querachse des PV-Moduls ausgerichtet sein. Hierdurch wird zwar nur ein geringer Beitrag für den Stromtransport entlang der Längsrichtung des PV-Moduls pro Solarzelle erzielt; diese bevorzugte Zellausrichtung ist aber unter anderem deshalb vorteilhaft, weil dadurch größere Anpassungen bestehender Fertigungsprozesse (die für die PV-Module notwendig sind) vermieden werden können. Damit wird es möglich auf herkömmlichen Fertigungsstraßen, die für herkömmliche Module ausgelegt sind, erfindungsgemäß ausgestaltete PV-Module einfach zu fertigen.

Bei dem zuvor erläuterten Design können somit die AnschlussTerminals an der Querseite des PV-Moduls angeordnet sein. Dadurch kann eine größere zusammenhängende photoaktive Fläche erhalten werden, zum Beispiel innerhalb einer gleichbleibenden Einhüllenden. Zudem können dadurch Verschattungen minimiert werden, da typischerweise in der Aufstellsituation an der Querseite ohnehin Verschattungen durch Pfosten unvermeidbar sind. Bei im Stand-der-Technik üblichen Halbzell-Modulen sind die Anschlussterminals (oftmals auch als "junction boxes" bezeichnet) häufig in der Mitte des Moduls angeordnet, wodurch die aktive Fläche gerade im Zentrum unterbrochen wird und zudem dort eine (unnötige) Abschattung entsteht. Die erfindungsgemäße Anordnung sorgt demgegenüber für eine große zusammenhängende, zentral angeordnete aktive Fläche des PV-Moduls, was den Stromertrag maximiert.

Zur Lösung der eingangs genannten Aufgabe wird noch ein weiteres Modul-Design vorgeschlagen, dass möglicherweise eigenständigen erfinderischen Charakter aufweist, aber dem Grund-Konzept folgt, einen Stromtransport entlang der (insbesondere gesamten) Längsseite des PV-Moduls anzustreben. Ausgehend von dem PV-Modul der eingangs genannten Art wird daher - alternativ oder aber ergänzend zu den bislang diskutierten erfindungsgemäßen Merkmalen - vorgeschlagen, dass einzelne der Substrings über die gesamte Längsseite des PV-Moduls verlaufen. Mit anderen Worten kann somit wenigstens eine elektrische Serie von unmittelbar benachbarten photoaktiven Zellen gebildet sein, die allesamt dieselbe (Netto-) Stromtransportrichtung zeigen und sich über die gesamte Längsseite des PV-Moduls erstrecken, um so einen Substring zu bilden, dessen Länge dem des PV-Moduls entspricht. Somit können bereits einzelne der Substrings einen Nettostromtransport entlang der gesamten Längsseite des PV-Moduls, also insbesondere in Richtung der Längsachse des PV-Moduls, liefern.

Bei einem derartigen Design kann die zuvor bereits erwähnte Polachse, die durch zwei Anschluss-Terminals des PV-Moduls verläuft, auch entlang der Querachse ausgerichtet sein. Bevorzugt sind aber Ausgestaltungen, bei denen die AnschlussTerminals an gegenüberliegenden Querseiten oder Ecken des PV-Moduls angeordnet sind. Denn in diesem Fall kann auch ein räumlicher Netto-Stromtransport in Längsrichtung des PV-Moduls erzielt werden.

Bei dem erläuterten Design mit einzelnen über die gesamte Längsseite des PV-Moduls verlaufenden Substrings kann auch vorgesehen sein, dass mehrere dieser Substrings so zu einem String elektrisch in Serie geschalten sind, dass eine Stromrichtung dieses Strings entlang der Längsachse des PV-Moduls verläuft. Dies ist insofern kein Widerspruch, da einzelne der Substrings eine Stromtransportrichtung entlang der Längsachse des PV-Moduls aufweisen können, während andere der Substrings des PV-Moduls eine entgegengesetzte Stromtransportrichtung aufweisen können. Das heißt, bei einer solchen Ausgestaltung kann insbesondere erzielt sein, dass der besagte String eine Hin-und-Her-Stromführung realisiert und zwar insbesondere auch gegebenenfalls ohne räumlichen NettoStromtransport in Längsrichtung des PV-Moduls.

Bei solchen Designs kann ferner vorgesehen sein, dass einzelne der Substrings mehr als vierundzwanzig, insbesondere mehr als sechsundzwanzig, elektrisch in Serie geschaltete N-Bruchteilzellen, insbesondere Halbzellen, aufweisen.

Es kann ferner beispielsweise vorgesehen sein, dass das PV-Modul mindestens drei Strings aufweist, die in Richtung der Querachse zueinander versetzt angeordnet sind. Hierbei können diese drei Strings insbesondere gleich lang und/oder in Richtung der Querachse zueinander ausgerichtet sein (insbesondere sodass diese drei Strings einen gemeinsamen Abschnitt entlang der Längsachse des Moduls einnehmen). In einem solchen Fall kann bei Verwendung des PV-Moduls in einer Querorientierung, in welcher die Längsseite horizontal ausgerichtet ist, gewährleistet werden, dass mindestens zwei, vorzugsweise mindestens drei, Substrings des Strings vertikal übereinander angeordnet sind, was die Anfälligkeit gegen Verschattungen minimiert.

Schließlich kann auch bei diesen Designs vorgesehen sein, dass das PV-Modul Bypass-Dioden aufweist, mit denen mindestens zwei der drei Strings elektrisch überbrückbar sind, um so bei Verschattungen eine zu starke Verringerung der Stromproduktion zu vermeiden.

Gemäß einer weiteren möglichen spezifischen Ausgestaltung, die sich insbesondere bei Verwendung von N-Bruchteilzellen anbietet, kann das PV-Modul mindestens drei Substrings aufweisen von denen zwei zu einem String elektrisch in Serie geschalten sind, während der dritte der drei Substrings zu dem besagten String elektrisch in Serie geschalten ist. Hierbei kann das PV-Modul, insbesondere zu jedem dieser drei Substrings, jeweils einen weiteren parallel geschalteten Substring aufweisen. Ferner kann vorgesehen sein, dass der jeweilige String eine Hin-und-Her-Stromführung ohne räumlichen Netto-Stromtransport in Längsrichtung des PV-Moduls realisiert. Schließlich kann bevorzugt der dritte der drei Substrings über eine zusätzliche Stromleitung, die entlang der gesamten Längsseite des PV-Moduls verläuft, elektrisch kontaktiert sein. Diese Stromleitung kann bevorzugt außerhalb einer Einhüllenden der photoaktiven Fläche des PV-Moduls angeordnet sein, beispielsweise indem Abzweigdosen am Rand des Moduls in entsprechender Orientierung verbaut werden.

Bei Designs mit entlang der gesamten Längsseite des PV-Moduls verlaufenden Substrings kann die Gesamtzahl an photoaktiven Zellen, die in einem der Substrings elektrisch in Serie geschalten sind, auf sechsundzwanzig, vorzugsweise auf fünfundzwanzig, besonders bevorzugt auf vierundzwanzig, begrenzt sein, um die zuvor angesprochene Durchbruchsspannung der photoaktiven Zellen nicht zu überschreiten.

Ferner kann bei erfindungsgemäßen Designs ergänzend oder alternativ vorgesehen sein, dass ein jeweiliger String des PV-Moduls mindestens zwei, insbesondere mindestens drei oder sogar mindestens vier Substrings aufweist. Hierbei können innerhalb eines Strings beispielsweise mindestens jeweils zwei Substrings parallel geschalten sein und/oder es kann beispielsweise nur ein einziger String zwischen zwei Anschluss-Terminals des PV-Moduls elektrisch geschalten sein. Bei Verwendung von beispielsweise drei Substrings innerhalb eines Strings kann somit die Gesamtzahl an photoaktiven Zellen dieses Strings (und damit des Moduls, sofern das Modul nur diesen einzigen String aufweist) nicht mehr als achtundsiebzig, vorzugsweise nicht mehr als zweiundsiebzig betragen.

Alle der zuvor beschriebenen Varianten führen zu PV-Modulen, die sich einerseits einfach fertigen lassen, mit verfügbaren elektrischen Komponenten zum Aufbau von PV-Anlagen kompatibel sind und gleichzeitig eine Stromführung bieten, die auf die Erfordernisse von bifazialer Stromproduktion in PV-Anlagen angepasst ist. Insbesondere ermöglichen solche Module eine einfache Tragkonstruktion.

Schließlich können die bislang vorgestellten PV-Module erfindungsgemäß dazu verwendet werden, eine PV-Anlage aufzubauen, bei der dann die PV-Module im Wesentlichen aufrechtstehend montiert werden, beziehungsweise montiert sind. Daher schlägt die Erfindung ausdrücklich auch die Verwendung eines wie zuvor beschriebenen oder nach einem der auf ein solches gerichteten Ansprüche ausgestalteten PV-Moduls zum Aufbau einer solchen PV-Anlage vor.

Die Erfindung schlägt somit auch eine PV-Anlage vor, die eine Tragkonstruktion aus im Wesentlichen vertikal verlaufenden Pfosten und im Wesentlichen horizontal verlaufenden Riegeln aufweist. Dadurch spannen die Pfosten und Riegel jeweilige (im Wesentlichen rechteckige) Montagefelder auf. In den Montagefeldern sind erfindungsgemäß bifaziale PV-Module angeordnet, die wie zuvor beschrieben oder nach einem der auf ein solches Modul gerichteten Ansprüche ausgestaltet sein können. Hierbei kann zum Beispiel innerhalb eines Montagefelds jeweils nur ein solches PV-Modul oder aber mehrere Module in Querorientierung montiert sein.

Die Erfindung wird nun anhand von Ausführungsbeispielen näher beschrieben, ist aber nicht auf diese Ausführungsbeispiele beschränkt. Weitere Ausbildungen der Erfindung können aus der nachfolgenden Beschreibung eines bevorzugten Ausführungsbeispiels in Verbindung mit der allgemeinen Beschreibung, den Ansprüchen sowie den Zeichnungen gewonnen werden.

Bei der folgenden Beschreibung verschiedener bevorzugter Ausführungsformen der Erfindung erhalten in ihrer Funktion übereinstimmende Elemente auch bei abweichender Gestaltung oder Formgebung übereinstimmende Bezugszahlen.

Es zeigt:
- Fig. 1: eine perspektivische teilweise schematisierte Ansicht eines Ausschnitts einer Photovoltaik-Anlage, die mehrere erfindungsgemäße bifaziale PV-Module aufweist,
- Fig. 2: eine schematische Skizze eines PV-Moduls, das aus dem Stand der Technik bekannt ist,
- Fig. 3: eine schematische Skizze eines ersten erfindungsgemäßen Designs eines PV-Moduls,
- Fig. 4: eine schematische Skizze eines zweiten erfindungsgemäßen Designs eines PV-Moduls,
- Fig. 5: eine schematische Skizze eines dritten erfindungsgemäßen Designs eines PV-Moduls,
- Fig. 6: eine schematische Skizze eines vierten erfindungsgemäßen Designs eines PV-Moduls, und
- Fig. 7: eine schematische Skizze eines fünften erfindungsgemäßen Designs eines PV-Moduls.

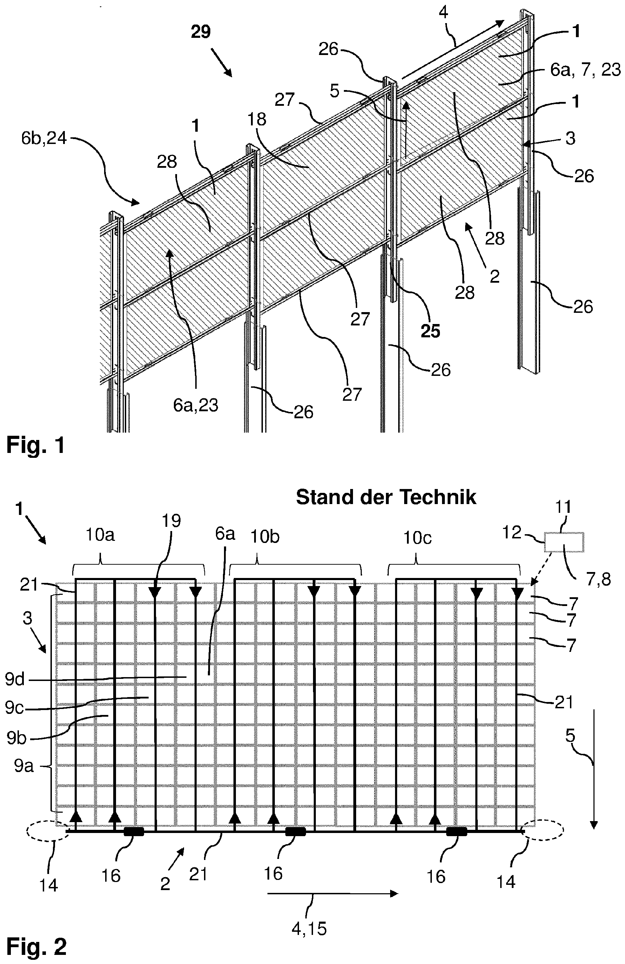

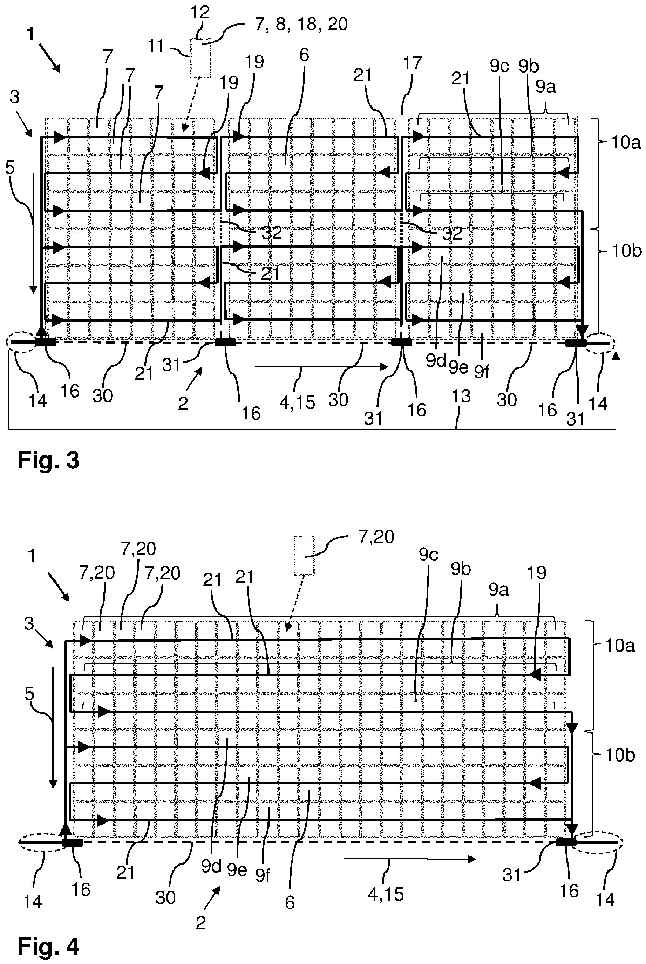

Die Figur 1 zeigt eine erfindungsgemäße Photovoltaik(PV)-Anlage 29, die eine Tragkonstruktion 25 umfasst, die aus vertikal verlaufenden, jeweils zweiteiligen Pfosten 26 und horizontal verlaufenden Riegeln 27 aufgebaut ist. Dadurch werden rechteckige Montagefelder 28 definiert, in welche je mindestens ein erfindungsgemäßes PV-Modul 1 mit rechteckiger Grundform 18 eingesetzt ist. Jedes der PV-Module 1 ist bifazial ausgebildet und bietet daher sowohl auf der Vorderseite 23 als auch auf der Rückseite 24 jeweils eine photoaktive Fläche 6, die ihrerseits von zahlreichen photoaktiven Zellen 7 (oftmals als Solarzellen bezeichnet) ausgebildet ist, wie noch genauer mit Bezug auf die Figuren 3 bis 7 erläutert wird.

In Figur 1 ist ferner noch zu erkennen, dass die PV-Module 1 jeweils aufrechtstehend montiert sind, um so Sonnenlicht auf der Vorder- und Rückseite 23, 24 zu unterschiedlichen Tageszeiten auffangen zu können. Hierbei sind die PV-Module 1 in Querorientierung montiert, d.h. sie stehen jeweils auf ihrer Längsseite 2 auf, während die kurze Querseite 3 in vertikaler Richtung (also in etwa 90° zur Horizontalen) ausgerichtet ist; es sind aber auch Anordnungen der PV-Module mit einem Winkel der Querseite 3 von 70°-90° zur Horizontalen möglich, je nach Aufstellungsort der PV-Anlage 29.

Die Figur 2 zeigt ein aus dem Stand der Technik bekanntes Design eines PV-Moduls 1, bei welchem zahlreiche photoaktive Zellen 7 in Form von sogenannten Halbzellen 8 mit rechteckiger Grundform 18 verwendet werden. Die Anschluss-Terminals 14 des PV-Moduls 1, über die dieses elektrisch in eine PV-Anlage 29 integriert werden kann, sind links und rechts schematisch angedeutet. Die Dreieckspfeile geben die Stromrichtung 19 an, wie sie sich bei normaler Stromproduktion aufgrund von Sonneneinstrahlung auf die photoaktive Fläche 6 des PV-Moduls 1 einstellt.

Wie in Figur 2 zu erkennen, ist das PV-Modul 1 in drei Blöcke von links nach rechts aufgeteilt, wobei jedem Block eine Bypass-Diode 16 zugeordnet ist. Innerhalb eines Blocks (beispielsweise des Blocks ganz links) sind je zwölf Halbzellen 8 zu einem Substring 9 elektrisch in Serie geschalten, wobei die Stromrichtung 19 innerhalb eines Substrings 9 vertikal (in der Zeichnung von oben nach unten oder umgekehrt), also in Richtung der kürzeren Querseite 3 / der Querachse 5 des PV-Moduls 1 verläuft. Dabei sind die beiden Substrings 9a und 9b zueinander parallel geschalten und gleichzeitig in Serie zu den ebenfalls parallel geschalteten weiteren Substrings 9c und 9d. Diese vier Substrings 9a, 9b, 9c und 9d bilden daher einen ersten String 10a aus, sodass sich die Spannungen von jeweils vierundzwanzig Halbzellen 8 innerhalb des Strings 10a aufaddieren. Tritt eine Abschattung innerhalb dieses ersten linken Blocks auf, so kann der erste String 10a elektrisch mit Hilfe der linken Bypass-Diode 16 überbrückt werden, die dann in Durchlassrichtung gepolt ist (Bypass-Betrieb). Ohne Abschattung produzieren die Zellen 7 des Strings 10a jedoch bei Bestrahlung eine elektrische Spannung, die die Bypass-Diode 16 in Sperrrichtung polt, sodass dann gerade kein Strom durch die Bypass-Diode 16 fließt (normaler Betrieb).

Wie in Figur 2 zu sehen ist, sind die Halbzellen 8 mit ihrer Längsseite 11 in Richtung der Längsachse 4 des PV-Moduls 1, also entlang dessen Längsseite 2, ausgerichtet, während die Querseite 12 der Halbzellen 8 jeweils in Richtung der Querseite 3 des PV-Moduls 1 ausgerichtet ist. Ein wesentliches Problem dieses vorbekannten Designs ist die komplexe Fertigung aber auch die Anfälligkeit gegen Verschattungen: Wird beispielsweise die obere Reihe von Zellen 7 verschattet, so wird die Stromproduktion des gesamten PV-Moduls 1 stark beeinträchtigt.

Die Figur 3 zeigt demgegenüber ein erstes erfindungsgemäßes Design eines bifazialen PV-Moduls 1 (gezeigt ist lediglich dessen Vorderseite 23 in stark schematisierter Form), welches eine rechteckige Grundform 18 aufweist mit einer Längsseite 2 und einer kürzeren Querseite 3, die jeweils (wie mittels Pfeilen illustriert) eine Längsachse 4 und eine Querachse 5 definieren. Die dargestellte photoaktive Fläche 6 der Vorderseite 23 wird durch mehrere Substrings 9 von elektrisch in Serie geschalteten photoaktiven Zellen 7 ausgebildet. Bei dem gezeigten Beispiel sind die photoaktiven Zellen 7 dabei als N-Bruchteilzellen 8, genauer als Halbzellen 8, ausgestaltet, wobei vergleichbare Designs auch mit Vollzellen ausgestaltet werden können.

Auffallend an dem Design gemäß Figur 3 ist, dass es Substrings 9 aufweist, wie etwa die Substrings 9a, 9b, 9c, die in Richtung der Querachse 5 räumlich nebeneinander angeordnet sind. Wird das PV-Modul 1 aufrechtstehend in Querorientierung wie in Figur 1 illustriert montiert, so liegen diese Substrings 9a, 9b, 9c somit räumlich übereinander (nämlich in vertikaler Richtung versetzt zueinander). Diese Anordnung wird ermöglicht, indem die Halbzellen 8 - anders als bei dem Design gemäß Figur 2 - mit Ihrer Längsseite 11 in Richtung der kurzen Querachse 5 des PV-Moduls 1 ausgerichtet sind. Damit ist die Stromrichtung 19 innerhalb eines Substrings 9 (die innerhalb eines Substrings 9 stets konstant ist, also ohne Richtungswechsel) in Richtung der Längsachse 4 des PV-Moduls 1 ausgerichtet (in Figur 3 zum Beispiel von links nach rechts für Substring 9a/9c und in umgekehrter Richtung für Substring 9b) .

Wie zu erkennen, ist das PV-Modul 1 gemäß Figur 3 ebenfalls in drei Blöcke aufgeteilt, wobei jeder Block analog ausgestaltet ist und (wie etwa der Block ganz rechts) je zwei Strings 10a, 10b aufweist, die ebenfalls in Richtung der Querachse 5 räumlich über- beziehungsweise nebeneinander angeordnet sind. Hierbei ist der obere String 10a durch die elektrische Serienschaltung der drei Substrings 9a, 9b, 9c (jeweils gebildet aus acht in Serie geschalteten photoaktiven Zellen 7) realisiert, während der untere String 10b auf analoge Weise realisiert ist. Die beiden Strings 10a, 10b sind dabei erkennbar elektrisch zueinander parallel geschalten und können daher gemeinsam mittels einer Bypass-Diode 16 elektrisch überbrückt werden. Hierzu sind separate Bypass-Stromleitungen 30 am unteren Rand des PV-Moduls 1 ausgebildet, die im normalen Strombetrieb, also dann, wenn gerade keine Verschattung auf der photoaktiven Fläche 6 auftritt, stromlos sind, da die Bypass-Dioden 16 im normalen Betrieb sperren.

Auffallend ist nun in Figur 3 - insbesondere im Vergleich zu dem Design gemäß Figur 2 - dass die Bypass-Stromleitungen 30, die allesamt außerhalb der Einhüllenden 17 angeordnet sind, jeweils im Bypass-Betrieb (also bei Ausfall einer der Zellen 7 oder bei Verschattung) Strom parallel zur Stromrichtung 19 der Substrings 9a, 9b, 9c und zudem parallel zu wenigstens zwei photoaktiven Zellen 7 (hier jeweils insgesamt entlang von je acht Zellen 7 des jeweiligen Substrings 9) bis zu einem jeweiligen elektrischen Knotenpunkt 31 transportieren können. Dieser Knotenpunkt 31 wird bei der gezeigten Ausführung durch eine jeweilige Bypass-Diode 16 ausgebildet, könnte aber auch beispielsweise durch eine Zusammenführung dreier elektrischer Leiter realisiert sein. Die Bypass-Diode 16 muss auch nicht zwingend den Knotenpunkt 31 bilden, sondern kann auch zum Beispiel geometrisch nahe diesem angeordnet sein.

Beispielsweise im ersten Block sind die beiden Strings 10a und 10b übereinander angeordnet und elektrisch parallel geschalten. Da im normalen Strombetrieb, auch dann, wenn keine Abschattung auftritt, die Effizienzen der jeweiligen Zellen 7 schwanken können (etwa bedingt durch Temperaturschwankungen oder Schwankungen der elektrischen Zellcharakteristika), ist eine Ausgleichstromleitung 32 ausgebildet. Über diese kann im Normalbetrieb ein Ausgleichsstrom fließen (entweder von oben nach unten oder umgekehrt in Figur 3), und so eine Differenz der produzierten Stromstärke in den beiden Strings ausgleichen.

Die drei Blöcke (von links nach rechts), die jeweils eine Parallelschaltung von zwei Strings 10 aus je drei in Serie geschalteten Substrings 9 (von je acht in Serie geschalteten Halbzellen 8) realisieren, sind in Figur 3 elektrisch in Serie geschalten, um einen gewünschten räumlichen NettoStromtransport 13 entlang der Längsachse 4 vom linken zum rechten Anschluss-Terminal 14 zu realisieren. Im Ergebnis ist somit kein Kabel mehr für diesen Stromtransport notwendig, wie bei derzeitig am Markt erhältlichen PV-Modulen 1. Hierfür ist von Vorteil, dass bereits jeder der gezeigten Substrings 9 einen räumlichen Netto-Stromtransport 13 entlang der Längsachse 4 erzielt. Dabei sind die Stromrichtungen 19 der einzelnen Substrings 9 zwar teilweise gegenläufig, aber durch die gewählte ungerade Anzahl von Substrings innerhalb eines Strings wird der gewünschte Netto-Stromtransport in Längsrichtung realisiert.

Die räumliche Anordnung und Ausrichtung der Bypass-Stromleitungen 30, die die jeweiligen Knotenpunkte 31 / die Bypass-Dioden 16 miteinander verbinden, stellt dabei sicher, dass auch im Falle einer Abschattung Strom weiterhin entlang der Längsachse 4 transportiert werden kann.

Durch die Ausrichtung der Substrings 9 in Richtung der Längsachse 4 (sodass deren jeweilige Stromrichtung 19 entlang der Längsachse 4 verläuft) wird in Figur 3 einerseits eine effiziente Fertigung des PV-Moduls 1 auf herkömmlichen Fertigungslinien ermöglicht, ohne größere Anpassung bestehender Prozesse. Zum anderen kann aufgrund der gewählten Verschaltung weiterhin ein Netto-Stromtransport 13 entlang der gesamten Längsachse 4 des PV-Moduls 1 beibehalten werden, wie dies auch bei dem vorbekannten Design gemäß Figur 2 der Fall war. Schließlich wird auch noch die Anfälligkeit gegen Verschattungen minimiert, da sich beispielsweise eine Abschattung des obersten Substrings 9a zwar negativ auf die Stromproduktion in den nachfolgenden Substrings 9b und 9c auswirkt, nicht jedoch auf die Stromproduktion in den weiteren Substrings 9 des unteren Strings 10b, da diese nicht in Serie zu dem Substring 9a geschalten sind. Im Gegensatz hierzu sind die Stromrichtungen der Substrings 9 des PV-Moduls 1 gemäß Figur 2 in Richtung der Querachse 5 ausgerichtet, sodass die Substrings 9 in Richtung der Längsachse 4 nebeneinander angeordnet sind, was die erwähnte Anfälligkeit gegen (insbesondere zeilenweise) Verschattungen bedingt.

Bei dem Design gemäß Figur 3 ist die Polachse 15, die durch die beiden Anschluss-Terminals 14 des PV-Moduls 1 verläuft erkennbar entlang der Längsachse 4 ausgerichtet. Ferner sind sowohl die Anschluss-Terminals 14 als auch alle drei Bypass-Dioden 16 außerhalb der angedeuteten Einhüllenden 17, die die photoaktive Fläche 6 des PV-Moduls 1 begrenzt, angeordnet, nämlich an der Längsseite 2 des PV-Moduls 1.

Es versteht sich, dass bei allen erfindungsgemäßen PV-Modulen 1 gemäß den Figuren 3 bis 7 eine jeweils analoge elektrische Verschaltung der photoaktiven Zellen 7, insbesondere spiegelbildlich, auf der Rückseite 24 des PV-Moduls 1 ausgebildet sein kann. Insofern gelten alle hier beschriebenen Merkmale analog für das elektrische Vorder- und Rückseiten-Design des jeweiligen PV-Moduls 1.

Anhand der drei Substrings 9a, 9b, 9c der Figur 3 ist ferner zu erkennen, dass bei diesem Design einzelne Substrings 9 innerhalb eines jeweiligen Strings 10 entgegengesetzte Stromrichtungen zeigen. Bei dem gezeigten Beispiel gilt dies für alle insgesamt sechs Strings 10 der photoaktiven Fläche 6. Hierdurch realisiert jeder dieser sechs Strings 10 jeweils eine mäandrierende Hin-Her-Hin-Stromführung, so etwa von links nach rechts nach links und wieder nach rechts für die drei Substrings 9a, 9b, 9c, wie anhand der Stromrichtungspfeile 19 erkennbar ist.

Dadurch, dass bei dem Design gemäß Figur 3 jeweils drei Substrings 9 zu einem String 10 elektrisch in Serie geschalten sind, ist somit jeweils eine Hin-Her-Hin-Stromführung mit zwei Stromrichtungswechseln durch den jeweiligen String 10 realisiert. Der dadurch erzielte Nettostromtransport 13 in Längsrichtung ermöglicht es, Kabellänge zur elektrischen Verbindung benachbarter PV-Module 1 einzusparen, wenn diese aufrechtstehend in einer PV-Anlage 29 verbaut werden (Vgl. Figur 1). Gleichzeitig kann auf herkömmliche Prozesse zur Herstellung der PV-Module 1 zurückgegriffen werden. Durch die Unterteilung des PV-Moduls 1 in in Querrichtung nebeneinander/ übereinanderliegende Strings 10 wird erreicht, dass die Stromproduktion weniger durch Verschattungen gestört wird, wie sie insbesondere bei der beabsichtigten stehenden/senkrechten Montage der bifazialen PV-Module 1 auftreten.

Das Design gemäß Figur 4 verfolgt den gleichen Ansatz, allerdings verlaufen hier die jeweiligen Substrings 9 jeweils über die gesamte Längsseite 2 des PV-Moduls 1. Bei diesem Design realisiert also jeder der beiden Strings 10a, 10b, die auch erneut in Richtung der Querachse 5 räumlich überbeziehungsweise nebeneinander angeordnet sind, einen räumlichen Netto-Stromtransport 13 entlang der gesamten Längsseite 2 des PV-Moduls 1, nämlich vom linken bis zum rechten Anschluss-Terminal 14. Auch jeder der Substrings 9a, 9b, 9c realisiert jeweils einen Netto-Stromtransport entlang der gesamten Längsseite 2. Dieser Netto-Stromtransport kann auch bei einer Abschattung etwa der beiden mittleren Substrings 9 noch aufrechterhalten werden, aufgrund der erfindungsgemäß angeordneten Bypass-Stromleitung 30, die erneut im Bypass-Betrieb (also dann wenn die linke Bypass-Diode 16 durchschaltet) Strom parallel zur Stromrichtung 19 der Substrings entlang von mehr als zwei Zellen 7 transportiert, nämlich hier entlang der gesamten Längsseite 4 der photoaktiven Fläche 6. Ferner ist jeder der Substrings 9 aus einer Serienschaltung von insgesamt vierundzwanzig Halbzellen 8 realisiert, wobei selbstverständlich auch andere Anzahlen verwendet werden können, mit dann anderen resultierenden Ausgangsspannungen der Strings 10 und einer dann auch größeren Länge des PV-Moduls 1. Die Gesamt-Anzahl N von 3x24 Zellen 7 pro String übersteigt hier deutlich die sonst üblichen Zahlenwerte.

In Figur 4 sind die beiden Strings 10a, 10b, die jeweils drei Substrings 9 aufweisen, elektrisch zueinander parallel geschalten, sodass sich eine Abschattung etwa im Bereich des unteren Strings 10b nicht auf die Stromproduktion des oberen Strings 10a auswirkt. Ferner zeichnet sich dieses Design erneut durch eine Polachse 15 aus, die mit der Längsachse 4 zusammenfällt. Durch die gewählte Verschaltung liegt elektrisch immer nur ein String 10 (bzw. mehrere parallel geschaltete Strings 10) zwischen den beiden AnschlussTerminals 14 und nicht eine Serie von Strings 10, wie bei den Designs gemäß den Figuren 2 und 3. Entsprechend ist auch nur eine einzige Bypass-Stromleitung 30 (am unteren Modulrand) vorgesehen / notwendig.

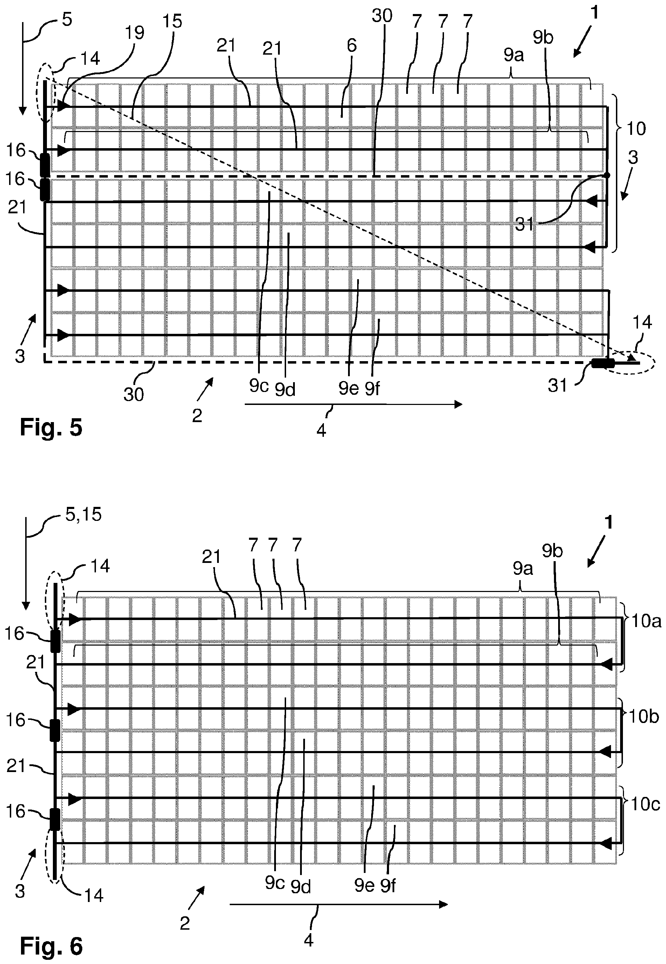

Wie bereits erläutert wurde, ist es für eine effiziente Stromproduktion von Vorteil, wenn in der Einbausituation (Vgl. Figur 1) mehrere elektrisch voneinander unabhängige Substrings 9 oder Strings 10 übereinander angeordnet sind. Dies liegt daran, dass bei Aufstellung der Tragkonstruktion 25 in mehreren zueinander benachbarten langen Reihen, je nach Sonnenstand, zeilenweise Verschattungen auf der jeweiligen photoaktiven Fläche 6 der PV-Module 1 auftreten. Die besagte Verschaltung, die solche zeilenweisen Verschattungen teilweise kompensieren kann, kann beispielsweise dadurch erreicht sein, dass die jeweilige aktive Fläche 6 eines PV-Moduls 1 mindestens zwei Strings 10 aufweist, die in Richtung der Querachse 5 des PV-Moduls 1 zueinander versetzt angeordnet sind, wie dies in den Figuren 3 bis 7 zu sehen ist. Hierbei kann auch vorgesehen sein, dass bei Verwendung des PV-Moduls 1 in Querorientierung (Vgl. Figur 1) mindestens zwei Strings 10 (Vgl. Figur 3 oder Figur 4), oder vorzugsweise sogar mindestens drei Strings 10 (Vgl. Figur 6) vertikal übereinander angeordnet sind.

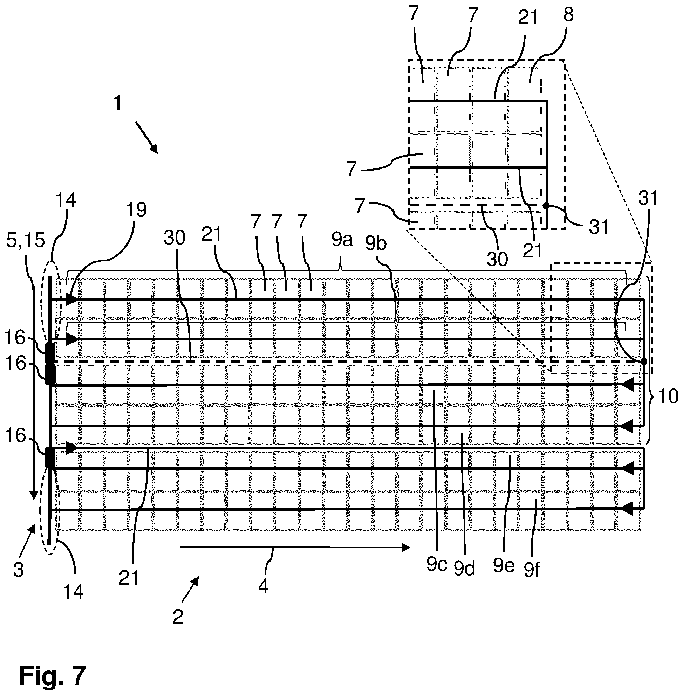

Bei dem Design gemäß Figur 7 ist jeder der drei Strings 10a, 10b, 10c, die jeweils mittels einer eigenen Bypass-Diode 16 einzeln elektrisch überbrückbar sind und die elektrisch in Serie geschalten sind, durch eine Parallelschaltung von je zwei übereinander liegenden Substrings 9a, 9b (aus bei diesem Beispiel je insgesamt vierundzwanzig Halbzellen 8, wobei auch andere Anzahlen möglich wären) gebildet. Jeder String 10 aber auch jeder der Substrings 9a, 9b liefert dabei einen NettoStromtransport 13 entlang der gesamten Längsseite 2 des PV-Moduls 1. Im Unterschied zu den Designs der Figuren 3 und 4 ist jedoch die Polachse 15, die durch die Anschluss-Terminals 14 verläuft, entlang der Querachse 5 ausgerichtet, was die Flexibilität der erfindungsgemäßen Designs zeigt. Denn je nach Tragkonstruktion 25 können unterschiedliche Positionierungen der Anschluss-Terminals 14 optimal sein. Bei dem Design gemäß Figur 7 wird dies durch eine zusätzliche Stromleitung 21 erreicht, die zwischen den beiden Strings 10b und 10c angeordnet ist und entlang der gesamten Längsseite 2 verläuft.

Zudem ist auch bei dem Design gemäß Figur 7 eine erfindungsgemäß ausgestaltete Bypass-Stromleitung 30 ausgebildet, die Strom parallel zur Stromrichtung 19 der Substrings 9a, 9b entlang der gesamten Längsseite 2 bis zu dem Knotenpunkt 31 transportiert. An diesem Punkt vereinigen sich die Bypass-Stromleitung 30 und die Stromableitung, die Strom aus den beiden obersten Substrings 9a, 9b zum Knotenpunkt 31 ableitet und eine weitere Stromzuleitung, die diesen Strom dem mittleren String 10b zuführt. Fällt somit der oberste String 10a wegen Verschattung aus, so schaltet die oberste BypassDiode 16 durch und liefert so Strom über die BypassStromleitung 30 bis zum Knotenpunkt 31 und versorgt so weiterhin den mittleren String 10b.

Das Design gemäß Figur 5 weist wie das der Figur 7 insgesamt drei Strings 10a, 10b, 10c auf, die jeweils mittels einer eigenen Bypass-Diode 16 einzeln elektrisch überbrückbar sind, zueinander elektrisch in Serie geschalten und jeweils durch eine Parallelschaltung von zwei Substrings 9a, 9b gebildet sind. Hierbei kann selbstverständlich auch die Serienschaltung der Strings 10a und 10b als ein String aufgefasst werden.

Ferner ist in Figur 5 auch erneut eine erfindungsgemäße Bypass-Stromleitung 30 vorgesehen, angeordnet zwischen den beiden obersten Strings 10a und 10b, die im Bypass-Betrieb einen Knotenpunkt 31 versorgt (analog zu Figur 7), indem diese Strom entlang der Stromrichtung 19 der Substrings 9 transportiert.

Man kann die elektrische Verschaltung der Figur 5 auch so auffassen, dass dort je zwei Paare aus je zwei parallel geschalteten Substrings 9a, 9b zueinander in Serie zu einem String 10 geschalten sind (der dann die obersten vier Reihen an Zellen 7 umfasst). In diesem Fall unterteilt aber gerade der Knotenpunkt 31 diesen String 10 elektrisch in jeweils mindestens einen Substring 9. Die Unterteilung ist dabei symmetrisch, da die Länge der Substrings 9 gleich ist (nämlich jeweils über die gesamte Längsseite 2), wobei die Substrings 9 gegenläufige Stromrichtungen 19 zeigen (obersten beiden Zeilen von links nach rechts, dritte und vierte Zeile von oben zeigen eine Stromrichtung von rechts nach links).

Denkbar wäre auch, die Bypass-Stromleitung 30 zu einem Knotenpunkt 31 zu führen, der nicht am Rand der photoaktiven Fläche 6 liegt, sondern an einem mittleren Abgriff. In diesem Fall wäre eine asymmetrische Unterteilung des Strings 10 erreicht, aber auch dann würden zumindest einige der Zellen 7 der so separierten Substrings 9 gegenläufige Stromrichtungen 19 zeigen.

In jedem Fall wird aber durch die in Figur 5 erfindungsgemäß ausgerichtete Bypass-Stromleitung 30 erreicht, dass die Gesamtzahl N an Zellen 7, die in dem besagten String 10 in Serie geschalten sind, eine maximale Anzahl M an Zellen 7 überschreiten kann, die mit der zugeordneten Bypass-Diode 16 sicher elektrisch betrieben werden können (In dem Sinn, dass die addierten M Leerlaufspannungen der Zellen 7 gerade noch unterhalb der Durchbruchsspannung einer jeweiligen photoaktiven Zelle 7 bleiben, sodass auch im Bypass-Betrieb kein elektrischer Durchbruch einer der Zellen 7 droht). Mit anderen Worten weist der durch die obersten vier Zell-Zeilen gebildete String 10 somit eine Gesamtanzahl N an photoaktiven Zellen 7 auf, deren aufsummierte Leerlaufspannungen eine Durchbruchsspannung einer der photoaktiven Zellen 7 übersteigen. Durch den Einsatz der Bypass-Leitung kann also ein String 10 von der in Figur 5 gezeigten Länge ausgebildet werden, wodurch sich die Länge des PV-Moduls 1 steigern lässt.

Da in Figur 5 auf eine zusätzliche Stromleitung 21 parallel zu einem Substring 9 (Vgl. Figur 7) verzichtet wurde, wird zudem bei diesem Design eine Hin-Her-Hin-Stromführung innerhalb der photoaktiven Fläche 6 erzielt (von links nach rechts nach links und wieder nach rechts), sodass insgesamt auch ein räumlicher Netto-Stromtransport 13 entlang der Längsachse 4 erfolgt.

Um dies auch im Bypass-Betrieb zu ermöglichen, ist unter anderem die (in Figur 5 gestrichelt dargestellte) obere Bypass-Stromleitung 30 (zwischen der zweiten und dritten Zell-Reihe von oben) entlang der Längsachse 4 ausgerichtet und verläuft über die gesamte Längsseite 2. Diese Bypass-Stromleitung 30 ermöglicht so, dass auch im Bypass-Betrieb, zum Beispiel bei Abschattung einer der obersten vier Zell-Zeilen, eine Hin-und-Her-Stromführung über die gesamte Längsseite 2 gewährleistet bleibt. Hierbei kann die Stromrichtung durch die Bypass-Stromleitung 30 variieren (von links nach rechts oder aber umgekehrt), je nachdem welche Zell-Zeile ausfällt. Sollten alle vier obersten Zeilen abgeschattet werden, so schalten beide Bypass-Dioden 16 am linken Rand des Moduls 1 durch, wodurch alles diese Zell-Zeilen elektrisch überbrückt werden können. Sollte hingegen eine der Zellen 7 in den beiden untersten Zell-Zeilen ausfallen, kann die entsprechende Zell-Zeile mittels der zweiten Bypass-Stromleitung 30 am unteren Rand des Moduls 1 überbrückt werden.

Wie schon bei dem Design gemäß Figur 4 verlaufen auch bei den Designs gemäß den Figuren 5 bis 7 einzelne Substrings 9 über die gesamte Längsseite 2 des PV-Moduls 1 (und definieren daher die Längserstreckung der jeweiligen photoaktiven Fläche 6). Dabei sind die jeweiligen Polachsen 15 bei den Designs gemäß den Figuren 6 und 7 jedoch entlang der Querachse 5 ausgerichtet (und die Anschluss-Terminals 14 entsprechend an der Querseite 3 angeordnet), während bei dem Design gemäß Figur 5 die Polachse 15 diagonal über das PV-Modul 1 verläuft, aber dennoch entlang der Längsachse 4 ausgerichtet ist, da die Komponente der Polachse 15, die entlang der Längsachse 4 verläuft, überwiegt. In Figur 5 sind die Anschluss-Terminals 14 dabei an Ecken der photoaktiven Fläche beziehungsweise an den sich gegenüberliegenden Querseiten 12 angeordnet.

Die Designs gemäß den Figuren 6 und 7 unterscheiden sich insofern von den Designs gemäß den Figuren 3 bis 5, dass bei diesen mehrere Substrings 9 so zu einem jeweiligen String 10 elektrisch in Serie geschalten sind, dass eine Stromrichtung 19 des Strings 10 zwar weiterhin entlang der Längsachse 4 des PV-Moduls 1 verläuft, aber ohne dass dabei ein räumlicher Netto-Stromtransport 13 in Längsrichtung des PV-Moduls 1 erzielt wird. Die Stromführung über die photoaktive Fläche 6 ist nämlich in Figur 6 und 7 jeweils erkennbar als eine Hin-und-Her-Stromführung ausgestaltet. Hierzu setzt das Design gemäß Figur 7 eine zusätzliche Stromleitung 21 ein (die entlang der gesamten Längsseite 2, zwischen der vierten und fünften Zell-Zeile von oben, verläuft), während bei dem Design gemäß Figur 6 jeder der drei Strings 10 jeweils eine Hin-und-Her-Stromführung (über die gesamte Länge des PV-Moduls 1) realisiert.

Bei dem Design gemäß Figur 6 weist jeder der Substrings 9 nicht mehr als vierundzwanzig elektrisch in Serie geschaltete N-Bruchteilzellen 20 auf. Diese Anzahl könnte aber auch höher liegen, etwa wenn Drittel- oder Viertelzellen anstatt Halbzellen 8 verwendet werden. In diesem Fall wären aber die Ausgangsspannungen der Substrings 9 höher.

Ein weiterer Unterschied der Designs gemäß den Figuren 5 bis 7 im Vergleich zu denen gemäß den Figuren 3 und 4 ist, dass erstere jeweils drei Strings 10 aufweisen, die in Richtung der Querachse 5 zueinander versetzt angeordnet sind und nicht nur zwei. Dadurch wird das PV-Modul 1 noch weniger anfällig gegen Verschattungen, da je nach momentaner Verschattungssituation jeder dieser drei übereinander angeordneten Strings 10 einzeln (und damit ca. ein jeweiliges Drittel der photoaktiven Fläche 6) elektrisch mit Hilfe der Bypass-Dioden 16 überbrückt werden kann.

Bei dem Design gemäß Figur 7 ist noch auffallend, dass in dem PV-Modul 1 insgesamt drei Parallelschaltungen von je zwei Substrings 9 zwischen den Anschluss-Terminals 14 in Serie geschalten sind. Durch die zusätzliche Bypass-Stromleitung 30, die über die gesamte Länge des PV-Moduls 1 verläuft, wird dabei sichergestellt, dass jeder der drei Strings 10a, 10b, 10c, einzeln überbrückt werden kann, sodass sich demnach eine Abschattung etwa des obersten Strings 10a nicht auf die anderen Strings 10b 10c auswirkt, obwohl der String 10a in Serie zu den beiden anderen Strings 10b und 10c geschalten ist.

Wie alle erfindungsgemäßen Designs gemäß den Figuren 3 bis 7 zeigen, kann trotz Verwendung von N-Bruchteilzellen 20 eine vergleichsweise große Länge des jeweiligen PV-Moduls 1 erzielt werden, was die Verwendung einer einfachen und daher kostengünstigen Tragkonstruktion 25 ermöglicht. Gleichzeitig wird, insbesondere bei den Designs gemäß den Figuren 4 und 6 (bei denen vollständig auf stromführende Leitungen zwischen den photoaktiven Zellen 7 verzichtet wird), eine große, zusammenhängende, zentral angeordnete, photoaktive Fläche 6 geschaffen, was den Stromertrag maximiert. Dabei wird die Anfälligkeit gegen Abschattung durch die Verwendung separater Strings 10, die in Einbausituation in horizontaler Richtung verlaufen, ermöglicht.

Zusammenfassend wird zur Optimierung eines Photovoltaik-Moduls 1 hinsichtlich der Bedingungen bifazialer Stromproduktion in PV-Anlagen 29 vorgeschlagen, dass das PV-Modul 1 in Querorientierung zur Stromproduktion verwendet wird und dass daher mehrere Substrings 9, die aus einer jeweiligen linearen Anordnung von in Serie geschalteten gleichartigen photoaktiven Zellen 7 bestehen, entlang einer Querachse 5 des PV-Moduls 1 zueinander versetzt angeordnet werden. Dabei können die Substrings 9 so elektrisch verschalten werden, dass sich ein Stromfluss durch die in Einbausituation übereinander angeordneten Substrings 9 während der Stromproduktion unabhängig voneinander einstellt, sodass Verschattungen teilweise elektrisch kompensiert werden können (Vgl. Figur 3).

### Bezugszeichenliste

- 1: Photovoltaik-Modul
- 2: Längsseite (von 6)
- 3: Querseite (von 6)
- 4: Längsachse
- 5: Querachse
- 6: photoaktive Fläche
- 7: photoaktive Zelle
- 8: Halbzelle
- 9: Substring (d.h. elektrische Serienschaltung von 7)
- 10: String (elektrische Serienschaltung von 9)
- 11: Längsseite (von 8)
- 12: (kürzere) Querseite (von 8)
- 13: räumlicher Netto-Stromtransport
- 14: Anschluss-Terminals
- 15: Polachse
- 16: Bypass-Diode
- 17: Einhüllende (von 6)
- 18: Grundform (von 1 oder 8)
- 19: Stromrichtung
- 20: N-Bruchteilzelle (z.B. 8)
- 21: Stromleitung
- 22: Abzweigdose (engl. "junction box")
- 23: Vorderseite (von 1)
- 24: Rückseite (von 1)
- 25: Tragkonstruktion
- 26: Pfosten
- 27: Riegel
- 28: Montagefeld
- 29: PV-Anlage
- 30: Bypass-Stromleitung
- 31: Knotenpunkt
- 32: Ausgleichsstromleitung

## Patentansprüche

1. **Bifaziales Photovoltaik-Modul (1),** mit
- je einer photoaktiven Fläche (6a, 6b) von rechteckiger Grundform (18) auf einer Vorderseite (23) und einer Rückseite (24) des PV-Moduls (1),
- wobei die photoaktiven Flächen (6a, 6b) je eine Längsseite (2) sowie eine kürzere Querseite (3) ausbilden, die jeweils eine Längsachse (4) beziehungsweise eine Querachse (5) des PV-Moduls (1) definieren, und
- wobei die photoaktiven Flächen (6a, 6b) jeweils durch mehrere Substrings (9) von elektrisch in Serie geschalteten photoaktiven Zellen (7) ausgebildet sind,
**dadurch gekennzeichnet,**
- **dass** eine jeweilige Stromrichtung (19) der Substrings (9) in Richtung der Längsachse (4) ausgerichtet ist und
- **dass** die Substrings (9) so elektrisch verschalten und angeordnet sind, dass insgesamt ein räumlicher NettoStromtransport (13) entlang der Längsachse (4) erzielbar ist.

2. **Bifaziales Photovoltaik-Modul (1)** gemäß dem Oberbegriff von Anspruch 1 oder gemäß Anspruch 1, wobei das PV-Modul (1) wenigstens eine Bypass-Diode (16) aufweist mit der mehrere der photoaktiven Zellen (7) elektrisch überbrückbar sind,
**dadurch gekennzeichnet,**
- **dass** an die wenigstens eine Bypass-Diode (16) eine im Normalbetrieb stromlose Bypass-Stromleitung (30) angeschlossen ist, die im Bypass-Betrieb Strom parallel zur Stromrichtung (19) eines der Substrings (9),
- vorzugsweise und parallel zu wenigstens zwei photoaktiven Zellen (7) dieses Substrings (9),
bis zu einem elektrischen Knotenpunkt (31) transportieren kann.

3. Bifaziales Photovoltaik-Modul (1) nach Anspruch 2,
- wobei wenigstens zwei der Substrings (9) elektrisch in Serie zu einem String (10) geschalten sind und der Knotenpunkt (31) den String (10) elektrisch unterteilt,
- vorzugsweise wobei der String (10) eine Serienschaltung von einer Anzahl N an photoaktiven Zellen (7) realisiert, deren aufsummierte Leerlaufspannungen eine Durchbruchsspannung der zugehörigen Bypass-Diode (16) übersteigen.

4. Bifaziales Photovoltaik-Modul (1) nach Anspruch 2 oder 3,
- wobei die Bypass-Stromleitung (30) entlang der Längsachse (4) ausgerichtet ist, vorzugsweise und über die gesamte Längsseite (2) verläuft, und/oder
- wobei die Bypass-Stromleitung (30) eine Hin-und-Her-Stromführung, insbesondere über die gesamte Längsseite (2) hinweg, durch einen String (10) ermöglicht,
- vorzugsweise wobei dieser String (10) von dem elektrischen Knotenpunkt (31) in wenigstens zwei Substrings (9) elektrisch unterteilt ist, deren photoaktive Zellen (7) zumindest teilweise gegenläufige Stromrichtungen (19) aufweisen.

5. Bifaziales Photovoltaik-Modul (1) nach einem der vorhergehenden Ansprüche,
- wobei eine Polachse (15), die durch zwei AnschlussTerminals (14) des PV-Moduls (1) verläuft, entlang der Längsachse (4) ausgerichtet ist,
- insbesondere wobei die Anschluss-Terminals (14) und/oder wenigstens eine Bypass-Diode (16) außerhalb einer Einhüllenden (17) der photoaktiven Flächen (6a, 6b) angeordnet sind,
- vorzugsweise wobei die Terminals (14) und/oder die wenigstens eine Bypass-Diode (16) an der Längsseite (2) angeordnet ist/sind.

6. Bifaziales Photovoltaik-Modul (1) nach einem der vorhergehenden Ansprüche,
- wobei einzelne der Substrings (9), die elektrisch zu einem String (10) in Serie geschalten sind, entgegengesetzte Stromrichtungen (19) zeigen,
- insbesondere sodass innerhalb dieses Strings (10) eine mäandrierende Hin-Her-Hin-Stromführung, vorzugsweise in Richtung der Längsachse (4), realisiert ist.

7. Bifaziales Photovoltaik-Modul (1) nach einem der vorhergehenden Ansprüche,
- wobei eine Gesamtzahl M an photoaktiven Zellen (7), die in einem der Substrings (9) in Serie geschalten sind, jeweils so begrenzt ist, dass eine Summe der Leerlaufspannungen der M Zellen (7) eine Durchbruchsspannung einer der photoaktiven Zellen (7) nicht übersteigt und/oder
- wobei ein jeweiliger String (10) des PV-Moduls (1) mindestens zwei, insbesondere mindestens drei oder sogar mindestens vier solcher Substrings (9) aufweist.

8. Bifaziales Photovoltaik-Modul (1) nach einem der vorhergehenden Ansprüche, wobei in einem der Substrings (9) eine Gesamtzahl N an photoaktiven Zellen (7) elektrisch in Serie geschalten sind, sodass eine Summe der Leerlaufspannungen der N Zellen (7) eine Durchbruchsspannung einer der photoaktiven Zellen (7) übersteigt,
- insbesondere wobei jeweils nur ein String (10) zwischen zwei Anschluss-Terminals (14) des PV-Moduls (1) elektrisch geschalten ist,
- vorzugsweise wobei mindestens zwei Strings (10) des PV-Moduls (1) zwischen den Anschluss-Terminals (14) elektrisch parallel geschalten sind.

9. Bifaziales Photovoltaik-Modul (1) nach einem der vorhergehenden Ansprüche, wobei wenigstens eine der aktiven Flächen (6a, 6b) mindestens zwei Strings (10) aufweist, die in Richtung der Querachse (5) des PV-Moduls (1) benachbart zueinander angeordnet sind,
- insbesondere sodass bei Verwendung des PV-Moduls (1) in einer Querorientierung, in welcher die Längsseite (2) horizontal ausgerichtet ist, mindestens zwei, vorzugsweise mindestens drei, Strings (10) vertikal übereinander angeordnet sind,
- vorzugsweise wobei das PV-Modul (1) Bypass-Dioden (16) zur elektrischen Überbrückung einzelner der Strings (10) aufweist.

10. Bifaziales Photovoltaik-Modul (1) nach einem der vorhergehenden Ansprüche, wobei die photoaktiven Zellen (7) jeweils als eine N-Bruchteilzelle (20),
- insbesondere als eine Halbzelle (8), Drittelzelle, oder Viertelzelle,
ausgestaltet sind, die aus einer vorprozessierten Vollzelle durch Teilung in N Bruchteile hergestellt wurde,
- vorzugsweise wobei die Bruchteilzellen (20) jeweils eine rechteckige Grundform (18) aufweisen beziehungsweise eine rechteckige photoaktive Fläche (6c) ausbilden.

11. Bifaziales Photovoltaik-Modul (1) nach dem vorhergehenden Anspruch, wobei eine jeweilige Längsseite (10) der N-Bruchteilzellen (20), insbesondere der Halbzellen (8), die länger ist als eine zugehörige Querseite (12) der N-Bruchteilzelle (20, 8), in Richtung der Querachse (5) des PV-Moduls (1) ausgerichtet ist.

12. Bifaziales Photovoltaik-Modul (1) nach einem der vorhergehenden Ansprüche, wobei einzelne der Substrings (9) über die gesamte Längsseite (10) verlaufen,
- vorzugsweise wobei die Anschluss-Terminals (14) an gegenüberliegenden Querseiten (3) oder Ecken des PV-Moduls (1) angeordnet sind.

13. Bifaziales Photovoltaik-Modul (1) nach einem der vorhergehenden Ansprüche, wobei mehrere der Substrings (9) so zu einem String (10) elektrisch in Serie geschalten sind, dass eine Stromrichtung (19) des Strings (10) entlang der Längsachse (4) verläuft,
- insbesondere wobei der String (10) eine Hin-und-Her-Stromführung ohne räumlichen Netto-Stromtransport entlang der Längsachse (4) realisiert.

14. Bifaziales Photovoltaik-Modul (1) nach einem der vorhergehenden Ansprüche, wobei das PV-Modul (1) mindestens drei Substrings (9) aufweist von denen zwei zu einem String (10) elektrisch in Serie geschalten sind, während der dritte der drei Substrings (9) zu dem besagten String (10) elektrisch in Serie geschalten ist, insbesondere
- wobei das PV-Modul (1) zu jedem dieser drei Substrings (9) jeweils einen weiteren parallel geschalteten Substring (9) aufweist und/oder
- wobei der jeweilige String (10) eine Hin-und-Her-Stromführung ohne räumlichen Netto-Stromtransport entlang der Längsachse (4) realisiert,
- vorzugsweise wobei der dritte der drei Substrings (9) über eine zusätzliche Stromleitung (21), die entlang der gesamten Längsseite (2) des PV-Moduls (1) verläuft, elektrisch kontaktiert ist.

15. **Photovoltaik-Anlage (29),** umfassend
- eine Tragkonstruktion (25) aus im Wesentlichen vertikal verlaufenden Pfosten (26) und im Wesentlichen horizontal verlaufenden Riegeln (27),
- wobei die Pfosten (26) und Riegel (27) jeweilige Montagefelder (28) aufspannen, und
- wobei in den Montagefeldern (28) bifaziale PV-Module (1) nach einem der Ansprüche 1 bis 14 angeordnet sind,
- insbesondere wobei innerhalb eines Montagefelds (28) jeweils nur eines der PV-Module (1) in Querorientierung montiert ist.
